# EUROPEAN PATENT SPECIFICATION

(11) **EP 4 304 804 B1**
(45) Date of publication and mention of the grant of the patent: **25.06.2025**
(21) Application number: 21711840.5
(22) Date of filing: 10.03.2021
(51) Int. Cl.: B23K 26/082, B23K 26/08, B23K 26/142, B23K 26/382, H05K 3/00, B23K 101/36, B23K 101/40, B23K 101/42, B23K 103/00

(54) **APPARATUS AND METHOD FOR LASER MACHINING OF A SUBSTRATE**
VORRICHTUNG UND METHODE ZUR LASERBEARBEITUNG EINES SUBSTRATS
DISPOSITIF ET METHODE POUR LE TRAITEMENT PAR LASER D'UN SUBSTRAT

(43) Date of publication of application: 17.01.2024
(73) Proprietor: Applied Materials Italia S.R.L., 31048 San Biagio di Callalta (TV) (IT)
(72) Inventor: FRANKLIN, Jeffrey L., Santa Cruz, California 95060 (US); FURIN, Valentina, 31100 Treviso (IT); CELLERE, Giorgio, 36040 Torri di Quartesolo (IT); VERHAVERBEKE, Steven, San Francisco, California 94107 (US); LESCHKIES, Kurtis, San Jose, California 95124 (US); CHEN, Han-Wen, Cupertino, California 95014 (US); GIBACK, Park, San Jose, CA 95120 (US)
(74) Representative: Zimmermann & Partner Patentanwälte mbB
(86) International application number: PCT/EP2021/056084
(87) International publication number: WO 2022/188969

(56) References cited:
- JP-A- 2003 285 175
- JP-A- H06 142 972
- JP-B2- 3 709 707
- JP-B2- 5 165 203
- JP-B2- 6 137 767

## Description

### FIELD

Embodiments of the present disclosure relate to an apparatus and a method for laser machining of a substrate. More specifically, embodiments described herein relate to an apparatus and a method for efficient and exact laser machining of a substrate, particularly a crystalline silicon (c-Si) substrate or a polymer composite substrate, particularly the formation of via holes in the substrate.

### BACKGROUND

There is an increasing demand for volume processing of substrates such as crystalline silicon (c-Si) substrates, particularly c-Si wafers, or substrates including polymer-based build-up films, such as Ajinomoto Build-up Films, in fields such as next-generation PCB (printed circuit board) manufacturing, display manufacture, or solar cell manufacturing. The substrates may be processed with laser machining methods, particularly laser drilling and laser cutting, to achieve high processing volume and high accuracy.

Challenges arise when processing substrates with high precision at high speed and therefore high laser energies. The substrates subject to the laser light incidence may become hot or even locally melt in undesired locations. In such a situation, a high precision can no longer be guaranteed. Even worse, in such a situation an ongoing laser exposure with unchanged parameters may result in a poor drilling efficiency and quality. The drilling process furthermore causes debris to be generated which might further disturb the exact processing, leading to a reduced precision of the laser machining. For cost reasons, the substrates are regularly thin and fragile and particularly susceptible to damage or breakage which additionally increases the difficulty of the machining process.

JP 2003 285175 A describes that a laser beam is made incident on the surface of a work object while a gas is being flowed along the surface of the work object and a plurality of holes are formed by moving an incident position. At this time, the incident position of the laser beam is moved in a direction that an angle between a vector in which the center of the hole which is already formed is made to be a starting point and the center of the hole to be formed next is made to be an end point and the vector to show the flow of the gas with a visual line parallel with the normal line on the surface of the work object is made to be 45° or more, and is not moved in a direction to be less than 45°. JP 3 709 707 B2 describes that via holes are bored by performing the cyclic shots of a laser beam one shot by one shot on each via hole boring parts in the shot area having one or two or more via hole boring spots of an insulating substrate in a plurality of cycles. JP 5 165 203 B2 describes a laser beam machining apparatus, a laser beam machining head and a laser beam machining method. JP 6 137 767 B2 describes a laser machining apparatus and method for forming a surface of a half-finished product. JP H06 142972 A describes a laser beam machining gas nozzle, a laser beam machining device and a laser beam machining method.

In view of the above, new methods and apparatuses for laser machining of substrates that overcome at least some of the problems in the art are beneficial.

### SUMMARY

According to an aspect, an apparatus for hole drilling in a substrate according to claim 1 is provided.

According to an aspect, a method for drilling holes in a substrate according to claim 7 is provided.

According to aspects, the method and apparatus for drilling holes as disclosed herein consists of one or two first laser beam movement directions, and one or two second laser beam movement directions. In those aspects, the laser is not moved in another direction during the hole drilling process other than for auxiliary actions such as, but not limited to, moving the laser to a starting position or guiding the laser back to a pause position.

According to aspects, the direction of the laser beam movement is never in the same direction as the fluid flow direction except when the laser beam movement is controlled such that the area which is subjected to the laser beam directly before the laser beam movement is more than one area distant, in particular more than 5 areas distant, from the area subjected to the laser beam directly after the laser beam movement. In addition, according to aspects, the angles between every direction in which the laser beam moves during the drilling process and the fluid flow direction is never smaller than 20° or larger than 340° except when the laser beam movement is controlled such that the area which is subjected to the laser beam directly before the laser beam movement is more than one area distant, in particular more than 5 areas distant, from the area subjected to the laser beam directly after the laser beam movement.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
FIG. 1 shows a schematic view of an apparatus for laser machining of a substrate according to embodiments described herein;
FIG. 2 shows a schematic view of an apparatus for laser machining of a substrate according to embodiments described herein;
FIG. 3 shows a schematic set of areas to be processed, and a laser beam movement between the areas in relation to a fluid flow;
FIG. 4 shows a schematic set of areas to be processed, and a laser beam movement between the areas in relation to a fluid flow;
FIG. 5 shows a schematic set of areas to be processed, and a laser beam movement between the areas in relation to a fluid flow;
FIG. 6 shows a schematic set of areas to be processed, and a laser beam movement between the areas in relation to a fluid flow;
FIG. 7 shows a schematic set of areas to be processed, and a laser beam movement between the areas in relation to a fluid flow;
FIG. 8 illustrates the angle q1 and q2 between the laser beam movement directions and the fluid flow direction;

### DETAILED DESCRIPTION

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

The application of the present disclosure particularly relates to the production of any type of multilayer electronic assembly, such as printed circuit boards (PCBs), semiconductor packaging, solar cells or photovoltaic cells, display devices, such as LCD, OLED or microLED-based screens, or any type of device requiring high-precision handling of c-SI wafers or substrates including polymeric films with holes provided therein.

According to an aspect, the substrate may be a silicon-based substrate, such as a crystalline silicone (c-SI) substrate or wafer. The substrate can include structures, functional layers or devices provided on the substrate, such as semiconductor devices, dielectric layers, doted layers, metal layers e.g. for providing electrical connections, or other structures commonly known in semiconductor manufacturing. The substrate can include polymer-based layers, such as dielectric films. The dielectric film can be a polymer film, such as a polymer composite film. Polymer-based layers can include films such as an Ajinomoto Build-up film. The substrate can be provided on a carrying structure, e.g. the substrate can be a polymer film provided on a silicon-based carrying structure, and drilling a hole can include drilling a hole in the polymer film but not the underlying silicon-based carrying structure.

As understood herein, a hole may refer to a through-hole that goes through the complete thickness of the substrate. A hole as understood herein may alternatively or additionally refer to a blind hole. In particular, the holes as understood herein may refer to an array of holes. The holes can be configured for the formation of vias in the substrate. The holes can be configured for providing components therein. The holes can be configured for modifying the mechanical, electrical or thermal characteristics of the substrate in a beneficial matter. The holes can be configured for allowing subsequent manufacturing operations including the holes.

According to aspects of the present disclosure, it is not envisaged to perform so-called percussion drills, i.e., to drill each hole in one action, such as a single laser exposure, laser incidence or "shot" only. Rather, it is proposed to drill each hole in an iterative process. The iterative process as used herein can be understood in that each hole is repeatedly subjected to a laser beam, each time for a certain time period called "shot" herein. Each shot aims at removing material from the area that is subject to the laser beam. In terms of thickness of the substrate, the material removed may, for instance, correspond to not more than 25% of the thickness of the substrate at the location of the area that is subjected to the laser beam, more particularly not more than 20% or even not more than 15%.

According to an aspect, the drilling process includes a laser system configured to apply a laser beam onto the substrate for removing material from a set of areas on the substrate. The laser system may include a laser light source including a laser emitter. The laser light source can include a solid state laser, a diode-pumped laser, a pulsed laser, and/or an ultraviolet (UV) or an infrared laser such as a CO₂ laser. The laser light source may be chosen according to the substrate material, e.g. according to beneficial embodiments, the wavelength of the laser beam can have a high absorption in the substrate material. Particularly, for c-SI substrates, an infrared laser with a wavelength above 1,000 nm may be chosen, and for polymer substrates, particularly ABF-based substrates, a UV laser with a wavelength below 400 nm may be chosen.

According to an aspect, the laser system may further include an optical assembly for focusing the laser light to form a laser beam. The laser beam may be a narrow beam with a high spatial coherence. The laser beam may be conical and/or focused on the substrate to provide a narrow exposure area, the narrow exposure area typically corresponding to the size, e.g. the diameter of a hole to be drilled, e.g. the narrow exposure area can have a diameter of 5 % to 90 % of the hole to be drilled, such as 20 % to 50 % or less than 40 %. According to an embodiment, an area to be subjected to the laser beam can have a shape with a circumference, and the laser beam can be directed onto predefined positions corresponding to the circumference of the areas.

According to an aspect, the laser system can include a laser beam orientating assembly. The laser beam orientating assembly can include one or more laser beam orientating mirrors. A surface of the laser beam orientating mirror could be polygonal. The laser beam orientating mirror may be movable, in particular rotatable. For instance, by directing the laser beam towards the laser beam orientating mirror at a first side of the laser beam orientating mirror, the laser beam may be directed to the substrate at a first area to be drilled. Once the laser beam orientating mirror is moved, turned, or pivoted, the laser beam might hit the laser beam orientating mirror at a second side which causes the laser beam to jump to the second area of the substrate to be drilled.

According to an aspect, the drilling process typically includes predefined positions on the substrate corresponding to the set of areas to be drilled in a predefined order, such as a sequence, particularly a sequence defining positions corresponding to the set of areas on the substrate to be drilled. An apparatus for drilling the areas can include a controller. The controller may be configured to control the laser movement beam according to the sequence, where the laser is only shot at the areas to be drilled. The region between the areas not designed to be drilled is not subjected to the laser beam. This can be done, for instance, by supplying a controllable laser beam orientating mirror, such as a mirror included in a galvanometric assembly, particularly a two-axis galvanometric assembly, such as a dual axis scanning galvo system.

According to an aspect, the laser beam orientating mirror may have a reflective surface that reflects the laser beam and directs the laser beam to a desired location on the substrate. The desired location on the substrate can be a first position, and the laser beam orientating mirror can be controlled to direct the laser beam to the first position and subsequently be controlled to direct the laser beam to a second position, which can be a desired location on the substrate. The transition between the first position and the second position may be fast and include a jumping of the laser beam between the first position and the second position. Particularly, the laser beam orientating mirror may be configured for enabling a fast transition between multiple positions, e.g. a transition from the first position to the second position may occur at a frequency of 0.1 to 100 kHz, 0.5 to 50 kHz or 1 to 30 kHz.

In addition or alternatively, according to an aspect, the laser beam orientating mirror may be configured for moving the laser beam continuously over the substrate, particularly an area of the substrate including the set of areas to be drilled. Continuously may include different speeds of the movement. The laser beam may be continuous. The laser beam may be repeatedly blocked by a shutter to avoid laser incidence in, for instance, the region between the areas to be drilled. The shutter may be controlled by the controller as described herein. The shutter may be controlled such that the predefined positions on the substrate corresponding to the set of areas can be drilled. In particular, the shutter may be controlled such that the region between the areas to be drilled is not exposed to laser light. Instead of the shutter or in addition to the shutter, the laser beam may be pulsed, e.g. by operating the shutter as described above, and/or by providing a laser light source configured for pulsed operation, such as a pulsed laser. According to an aspect, a laser light source configured for pulsed operation may include a laser light source configured for Q-switching, i.e. including a Q-switch, such as an active or a passive Q-switch, and/or a laser light source including an acousto-optic modulator to pulse the laser.

According to an aspect, in typical embodiments described herein, an array of holes may be produced in the substrate, the array consisting of n rows and m columns with n and m being integer numbers. Consequently, a number of m times n holes in total have to be drilled. In further embodiments, the array can include not drilling a set of holes in the n·m substrate. The array may have, by design, "missing" holes or sections. An array may include several sub-arrays, the sub-arrays being definable as n·m arrays. According to embodiments, complex patterns may be formed, based on a number of sub-arrays, the sub-arrays being arrays as described herein.

According to an aspect, the device and method described herein are configured for processing a substrate to produce a set of holes, i.e. process areas on the substrate, including at least 1,000 areas, particularly at least 10,000 areas, or at least 100,000 areas.

According to an aspect, a single array of holes can be produced in the substrate. According to an embodiment, several arrays of holes can be produced in the substrate. An array of holes can include a set of areas. A substrate can be processed to include several arrays of holes, i.e. several sets of areas, such as at least 2 sets, at least 4 sets, at least 6 sets or at least 10 sets. According to aspects of the present disclosure, the holes of a first array may be drilled until they are completed, and subsequently the holes of a second array may be drilled until they are completed (and so on in the case of even more arrays, e.g. in the case of at least 4 arrays).

Producing several arrays of holes can include producing an array of holes in a first section of the substrate as described herein, moving the substrate in relation to the apparatus, and producing a subsequent array of holes in a second section of the substrate. According to embodiments, the apparatus can include a substrate support, such as a susceptor, holder, working table or the like configured for providing the substrate thereon and moving the substrate in relation to the apparatus, e.g. after a set of areas is processed, such as a two-axis work table or a rotary work table. According to embodiments, instead of moving the substrate, the substrate can remain stationary during processing, and laser system can be repositioned such that the laser system is moved in relation to the substrate or the apparatus.

Subsequently producing several arrays of holes can particularly be beneficial in cases where the workable area or "field of view" of the laser system is smaller than the total substrate area to be processed. In one example, the laser system can have a "field of view" corresponding to the area which can be processed by the laser system, with the set of areas lying within the field of view. The field of view can be at least 50 mm by 50 mm, at least 100 mm by 100 mm, at least 165 mm by 165 mm or even at least 250 mm by 250 mm.

According to an aspect, in embodiments, the laser beam is directed at each position corresponding to an area to be drilled at least three times, or even at least five times or even at least ten times. The drilling process may particularly be designed in a way that the number of shots causes the holes to have the predefined depth in the substrate. In particular, the predefined depth may be the substrate thickness. In this case, the drilling process is designed such that the number of shots is predefined such that through-holes are produced.

According to an aspect, in embodiments, the number of times the laser is directed onto the set of areas is a function of the substrate thickness depending on the substrate material, i.e. a thin substrate may be exposed to less pulses or shots than a thick substrate. The number of times the laser is directed onto the set of areas can be larger than a tenth of the substrate thickness in micrometers. In a first example, the laser is repeatedly directed onto an area of a silicon substrate with a thickness of 100 µm or less at least 5 times. In a second example, the laser is repeatedly directed onto an area of a silicon substrate with a thickness of 1000 µm or more at least 200 times. In a third example, the laser is repeatedly directed onto an area of a polymer film or polymer composite film substrate with a thickness of 100 µm or less at least 20 times. In a fourth example, the laser is repeatedly directed onto an area of a polymer film or polymer composite film substrate with a thickness of 1000 µm or more at least 400 times. In the examples, a through-hole is obtained.

According to an aspect, at least half of the subjected areas are allowed to cool for at least 50 ms after each time an area from the set of areas is subjected to the laser beam, particularly before the area is again subjected to the laser beam. The area can be allowed to cool for at least 60 ms, for at least 80 ms, or for at least 100 ms, or even for at least 500 ms. According to embodiments, each area of the subjected areas is allowed to cool. In a beneficial example, the area is allowed to cool while another area is processed, particularly, the set of areas can be continuously processed while an individual area in the set of areas is allowed to cool.

According to an aspect, in embodiments, the method for drilling and the controller configured to control the laser beam are designed such that all holes of the substrate are equal in size (e.g. measured as diameter) and/or depth. "Equal" in this context can be understood as a theoretic equality that shall include deviations in practice due to, for instance, slightly varying material properties of the substrate or the like.

By repeatedly directing the laser beam onto each position corresponding to the set of areas several times and allowing the area to cool after being subjected to the laser beam, the uniformness and positioning of the resulting holes can be improved. Furthermore, localized heating of the substrate can be avoided, which can result in higher uniformity between holes at the edges of the set of areas and holes in the center of the set of areas.

It was experimentally observed that in some cases, debris produced while subjecting an area to the laser beam may interfere with the drilling operation of adjacent areas under some conditions, e.g. by scattering or absorbing the laser light in an undesired manner. This can limit the obtainable speed or quality of the drilling operation. Such undesired effects can be overcome by aspects of the apparatus and method herein described in further detail.

According to an aspect, a ventilation system is provided. The ventilation system is configured to produce a fluid flow along one or more sides of the substrate. The one or more sides of the substrate typically include a face of the substrate, particularly the face of the substrate including the set of areas to be drilled. The fluid flow is directed in a fluid flow direction. The fluid flow can be unidirectional, i.e. the fluid can, for each area of the set of areas, flow in a substantially identical direction.

According to an aspect, the fluid flow may include a gas such as air, an inert gas or mixtures thereof. The gas may be chosen according to the properties of the substrate or the laser beam. In an example, the gas may be devoid of oxygen to prevent oxidation or combustion of the substrate or debris, or the creation of ozone when a low-wavelength laser beam is used. The gas may be dried to reduce infrared absorption of the gas, particularly when an infrared laser beam is used. The gas may include nitrogen. The gas may include a noble gas, such as helium or argon. The ventilation system may include a circulation system to recirculate the fluid flow.

According to an aspect, an apparatus may include an enclosure. The enclosure can enclose the laser system, the substrate support and/or the substrate. The enclosure can include ports for substrate loading and unloading, such as a load-lock chamber or a door. The enclosure can be configured for providing the fluid flow, and for maintaining the fluid composition, i.e. for enclosing a gas as described above. The enclosure can include a gas inlet and a gas outlet. The gas inlet and the gas outlet can be fluidly connected to the ventilation system, particularly for providing the fluid flow within the enclosure. The enclosure can form a part of the ventilation system.

According to an aspect, the fluid flow can be laminar or substantially laminar. Laminar, in the context of this disclosure, can be defined as a fluid flowing without substantially turbulent characteristics. Laminar, in the context of this disclosure, can further be understood as a flow without substantial lateral mixing between volumes comprising the flow, such as the volumes of the flow as defined by the spacing between the areas of the set of areas for each area, e.g. along the spatial dimensions defining the face of the substrate, or all spatial dimensions, particularly the volume of the fluid flow adjacent to the face of the substrate, particularly the volume including the space up to 2 mm above the face of the substrate. The fluid flow may include non-laminar portions in areas not adjacent to the face of the substrate.

The flow can have a flow-rate or velocity of more than 1 m/s in the volume comprising the space of 1 mm to 2 mm above the one or more sides of the substrate, or more than 2 m/s, such as 2 to 5 m/s, or more than 5 m/s, such as more than 10 m/s. The fluid flow volume may be expressed in terms of cubic feet per minute (CFM), with an apparatus designed for processing 100 mm by 100 mm substrates typically having a fluid flow volume of at least 100 CFM (0.04719474432 m³/s), particularly more than 200 CFM (0.09438948864 m³/s).

According to an aspect, the fluid flow carries away at least a portion of the debris produced when subjecting an area to the laser beam. The debris can include solids or a gas, or mixtures with substantially gas-like properties, such as ionized gas, aerosols or vapors, such as suspended particles and/or evaporated substrate material produced by the substrate during the laser exposure. Carrying away the debris can include carrying away the debris before again subjecting the area to the laser beam. Carrying away the debris can include carrying the debris in the direction of the fluid flow, and, in some cases, over other areas of the set of areas. It can be beneficial to not subject areas to the laser beam while debris from other areas is present above an area, as is described in further detail herein.

According to an aspect, the laser beam as described herein typically has a first movement direction and a second movement direction. The movement direction can be understood as the direction of the movement between a first area and a second area, the areas being areas subsequently subjected to the laser beam. The laser beam may be inactive during the movement defining the movement direction, i.e. when the laser beam is moved from a first position to a second position according to the movement direction, areas not intended to be subjected to the laser beam may be crossed, and the laser beam may be turned off, e.g. by means of the shutter. The laser beam movement direction can be defined in relation to the surface of the substrate, i.e. the movement direction can be a movement direction along a two-dimensional plane, the plane being formed by the face of the substrate having the set of areas to be drilled provided thereon. Similarly, the fluid flow direction can be a direction of the fluid flow in relation to a plane as defined by the substrate.

According to an aspect, the first movement direction and the second movement direction can be a movement direction of the laser beam between areas of the set of areas. The areas, particularly the areas defining a first laser beam movement direction, can be adjacent. The first movement direction and the second movement direction may be different, e.g. have an angle therebetween along the plane as defined by the substrate. In typical embodiments, the angle between the first movement direction and the second movement direction may be +90° and/or -90°. Areas of the set of areas can be adjacent if the area can be reached without crossing other areas of the set of areas. Areas of the set of areas can be adjacent if the areas have the closest spacing within the set of areas. Adjacent, in the context of this disclosure, should not be understood as requiring a contacting of the areas, i.e. adjacent areas can be physically spaced apart.

According to aspects, the first movement direction may change during the drilling process at least once, in embodiments a plurality of times. In particular, the first movement direction may be in a specific direction for a first number of areas, and be in the opposite direction for a second number of areas. According to aspects, the second movement direction may change during the drilling process at least once, in embodiments a plurality of times. In particular, the second movement direction may be in a specific direction for a first number of areas, and be in the opposite direction for a second number of areas.

According to an aspect, the movement direction, particularly the second movement direction, can be a movement direction of the laser beam between non-adjacent areas of the set of areas under some conditions, as defined in detail below. Areas of the set of areas can be non-adjacent if the area can be reached only by crossing, directly or indirectly, other areas of the set of areas. Areas of the set of areas can be non-adjacent if the areas have other areas spaced between the non-adjacent areas that are adjacent and/or areas that are closer to any of the non-adjacent areas than the non-adjacent areas are to each other.

Areas, including closely spaced areas, can be non-adjacent if a laser beam movement in the direction of one area to the subsequent area would allow the laser beam movement to reach another area before the subsequent area. Areas can be non-adjacent if the laser beam movement is such that the area which is subject to the laser beam in the sequence after the laser is moved by the laser beam movement is more than one area distant, more than five areas distant, particularly at least more than 10 areas distant from a prior area subjected to the laser beam in the sequence.

According to an aspect, the angle between the first laser beam movement direction and the fluid flow direction is defined as q1, and the angle between the second laser beam movement direction and the fluid flow direction is defined as q2. For example, if a laser beam movement direction is parallel to the fluid flow, the angle is 0°. If a laser beam movement direction is opposite to the fluid flow, the angle is 180°. If a laser beam movement direction is orthogonal to the fluid flow, the angle is 90° or 270°. In embodiments, the apparatus and method described herein can be achiral with respect to the definition of q1 and q2, thus, an angle of 90° and 270° may be equivalent and/or the value space may be defined by angles ranging from 0° to 180°. By defining the sequence of areas to be subjected to the laser beam and/or performing the hole drilling according to a defined relation between q1 and q2, the debris of each area can be carried away such that the debris does not interfere with subsequently subjected areas. Beneficial embodiments including preferred ranges and examples for q1 and q2 are described in further detail below.

Referring now to the figures, the general aspects discussed above are described in further detail and in relation to embodiments.

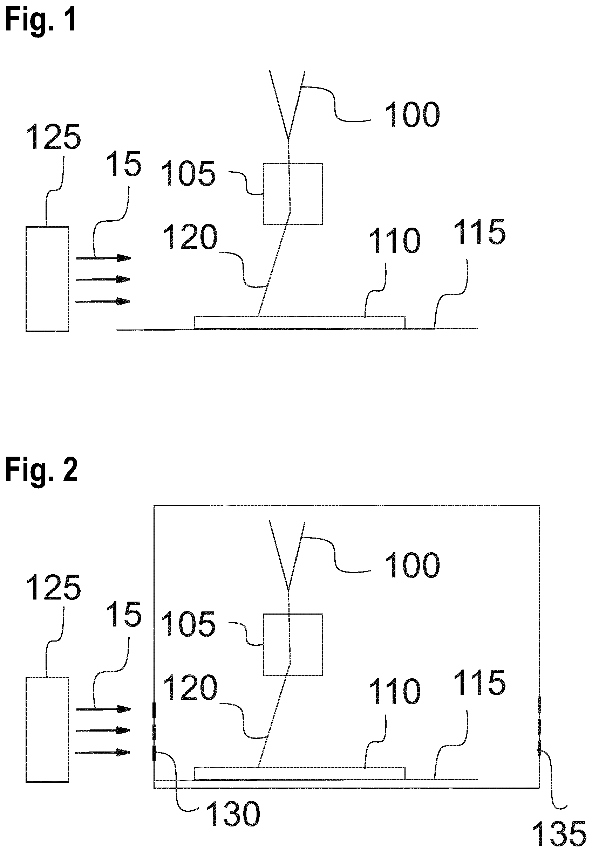

Fig. 1 is a schematic illustration of an apparatus according to an embodiment of the present disclosure. The laser 100 emits a laser beam 120. The laser beam may be emitted directly onto the substrate 110. Generally and not limited to this set-up, an actuator (not shown) may be provided for moving the laser. Moving may include translational movements and/or rotational movements. In the embodiment of Fig. 1 as illustrated, the laser beam is directed to a beam director 105. The beam director 105 may in particular include one or more mirrors and/or one or more lenses for guiding the laser beam, such as to have the laser beam follow the predefined sequence. Additionally or alternatively, the beam director may include a shutter. The shutter is typically controlled by the controller to block the laser beam during blocking times, and to allow the laser beam to pass during irradiation times. In particular, a shutter may block the laser beam so as to avoid that the substrate is subjected to the laser beam outside the areas to be drilled.

According to embodiments, the shutter may be controlled such that the shutter blocks the laser beam between two shots. For instance, a first shot may be applied to the substrate at a position on the substrate corresponding to an area to be drilled. The laser beam may subsequently be blocked by the shutter, and the laser beam may be directed to a second area to be drilled thereafter while the shutter no longer blocks the laser beam. As used herein, the control of the shutter may be aligned with the control of the laser beam movement.

The substrate 110 may rest on a substrate support 115. The substrate support may be movable. In other embodiments, the substrate support may be fixed. The apparatus of the present disclosure may include a substrate mover, such as a gripper, to position the substrate on the substrate support. The substrate support may include underpressure suction units configured to apply underpressure to the substrate's bottom so as to guarantee that the substrate is fully at rest despite the laser machining.

The apparatus of the present disclosure may additionally include the ventilation system 125. As illustrated, the ventilation system produces a fluid flow 15. The fluid flow 15 as discussed in the present disclosure is typically oriented parallel to the substrate support surface and/or the substrate. The fluid flow is supposed to produce a flow 15 that transports or carries away debris that is produced during the laser machining. In particular, the present disclosure provides the benefit that the control of the laser movement is designed in relation to the fluid flow direction so as to optimize the drilling process and to guarantee that debris produced during the drilling of an area does not negatively affect the drilling of another area, such as a neighboring or adjacent area.

As exemplarily illustrated with respect to Fig. 2, the apparatus may include an enclosure. The ventilation system 125 may be provided outside the enclosure. An inlet opening 130, such as the channels shown in Fig. 2, may be provided that guide the fluid flow into the enclosure. The substrate may be provided inside the enclosure. The enclosure may furthermore include an outlet opening 135 to allow the fluid flow to exit the enclosure. In alternative embodiments, the ventilation system is provided within the enclosure. Furthermore, in embodiments that can be combined with any of the previously described embodiments, a fluid flow suction system may be provided. The fluid flow suction system may be configured to suck in the fluid flow provided by the ventilation system. In this way, a closed fluid flow may be provided that may be particularly optimized in removing debris and the like from the substrate. The outlet opening 135 may be connected by a fluid transport system, such as a circulatory system, to the ventilation system 125 to allow the recirculation of the fluid. Filters may be provided for filtering debris from the fluid after exiting the outlet opening 135.

According to an aspect, the sequence for directing the laser beam onto the substrate for removing material from the areas of the set of areas is defined so as to fulfill either of the following three conditions:
1.) Both cos q1 and cos q2 are smaller than or equal to 0. In other words, q1 or q2 both are in a range between 90° and 270°. The first or second laser beam movement direction can, in relation to the fluid flow direction, lie within this range, i.e. the movement direction can be orthogonal to the fluid flow or be a direction which has, in addition to the orthogonal movement, a movement component which is opposite to the fluid flow direction. In one example, this condition is fulfilled if one of the first laser movement direction and the second laser movement direction is opposite to the fluid flow direction and/or wherein one of the first laser movement direction and the second laser movement direction is perpendicular to the fluid flow direction.
2.) each of q1 and q2 is larger than 20° and smaller than 340°; or
3.) q1, or q2, is smaller than 20°, or larger than 340°, and the laser beam movement is controlled such that the area which is subjected to the laser beam in the sequence is more than one area distant from the prior area subjected to the laser beam in the sequence. In this condition, the laser beam movement direction has a movement component which coincides with the flow direction. Adjacent areas may be subjected to the debris of the prior area subjected to the laser beam, however, distant areas may be unaffected. In beneficial examples, this condition is only chosen for one of the first laser beam movement direction or the second laser beam movement direction. In beneficial examples, this condition is only chosen when alternative movement directions, e.g. according to conditions 1.) or 2.), are unavailable, or if the movement according to condition 3.) allows several subsequent operations according to conditions 1.) or 2.).

In the following, several example sequences for the laser movement shall be discussed with reference to the figures.

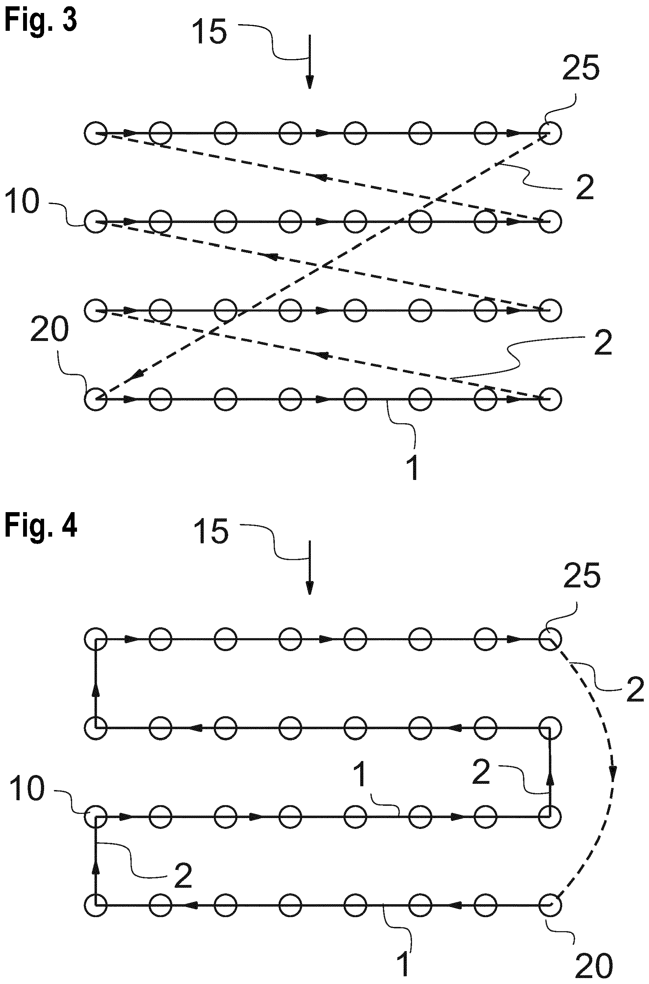

As exemplarily illustrated in the Figures 3 to 7, the circles 10 represent the areas that are supposed to be drilled. In order to not overload the figures, only a few of these circles are denoted explicitly by the reference number 10. The flow as provided by the present disclosure has the direction as indicated by the arrow 15 in the figures. The first laser beam movement direction is generally depicted as a solid line, and the second laser beam movement direction is generally depicted as a dotted line, however, this shall not be regarded as a limitation, and exceptions from this convention become clear in the examples that follow. According to a general aspect, which can be included in or combined with all embodiments described herein, the first laser beam movement direction can be a direction of a movement of the laser beam between adjacent areas, and/or the second laser beam movement direction can be a direction of a movement of the laser beam between non-adjacent areas.

Referring now to Fig. 3, a set of areas on a substrate according to an embodiment is shown. For ease of illustration, the following figures show set of areas that include fewer areas as compared to the applications of the present disclosure. The set of areas as illustrated is provided as a 4 by 8 array. Each area of the set of areas is subjected multiple times to the laser beam according to a sequence of shots. A fluid flow 15 is provided, having a direction as indicated by the arrow. The sequence can begin e.g. in the bottom left area 20. The following areas are subsequently subjected to the laser beam along a line 1, i.e. the first laser beam movement direction, represented as a solid line, having an angle q1 of 90° relative to the fluid flow direction and thus fulfilling condition 1.).

When the bottom right area is reached, the laser beam is moved in a second laser beam movement direction (dotted line) to reach the leftmost area of the next line of areas. The second laser beam movement direction 2 has an angle q2 of 260° relative to the fluid flow direction and thus fulfills condition 1.).

The operations are repeated until the top right area 25 is reached, after which the second laser beam movement direction 2 is adjusted to return the laser beam to the bottom left area 20. The second laser beam movement direction 2 for this movement in relation to the fluid flow direction q2 is 300°, thus, neither conditions 1.) or 2.) are fulfilled. However, the top right area is several areas distant from the bottom left area, thus, condition 3.) is fulfilled.

Referring now to Fig. 4, a set of areas according to an embodiment is shown. The set of areas may be the set of areas described in relation to Fig. 3, thus, only the differences in the positioning of the laser beam are described. The sequence can begin e.g. in the bottom right area 20. The following areas (illustrated in the lowermost line) are subsequently subjected to the laser beam along a line, i.e. the first laser beam movement direction 1, represented as a solid line, having an angle q1 of 270° relative to the fluid flow direction and thus fulfilling condition 1.).

When the bottom left area is reached, the laser beam is moved in a second laser beam movement direction 2 to reach the leftmost area of the next line of areas. The second laser beam movement direction is opposite to the fluid flow direction and therefore has an angle q1 of 180° relative the fluid flow direction and thus fulfills condition 1.).

The following areas along the line are subsequently subjected to the laser beam as before, however with the first laser beam direction 1 being adjusted to move in the opposite direction to the previous first laser movement direction, represented as a solid line, having an angle q1 of 90° relative to the fluid flow direction and thus fulfilling condition 1.).

The operations are repeated until the top right area 25 is reached, after which the second laser beam movement direction is adjusted to return the laser beam to the bottom right area. The second laser beam movement direction 2 for this movement is identical to the fluid flow direction, and therefore q2 is 0°. For such a situation, neither conditions 1.) nor 2.) are fulfilled. However, the top right area 25 is several areas distant from the bottom right area 20, thus, condition 3.) is fulfilled. It should be noted that the transition from area 25 to area 20 is depicted in Fig. 4 as a curved line for reasons of intelligibility only, i.e. the transition may be performed according to a straight line between area 25 and 20. The debris from the drilling of the area denoted with reference number 25, however, does not jeopardize the further drilling operation after this movement in the second laser beam movement direction along the angle q2=0° because, in practice, the area where the laser is located after this movement (denoted with reference number 20° in Fig. 4) is at least 10 areas, more specifically at least 20 areas away from the area before this movement. In addition, the transition between area 25 and 20 may be performed slowly or in a delayed manner to ensure that any debris produced by the processing of area 25 has been cleared by the fluid flow so as to not interfere with the processing of area 20.

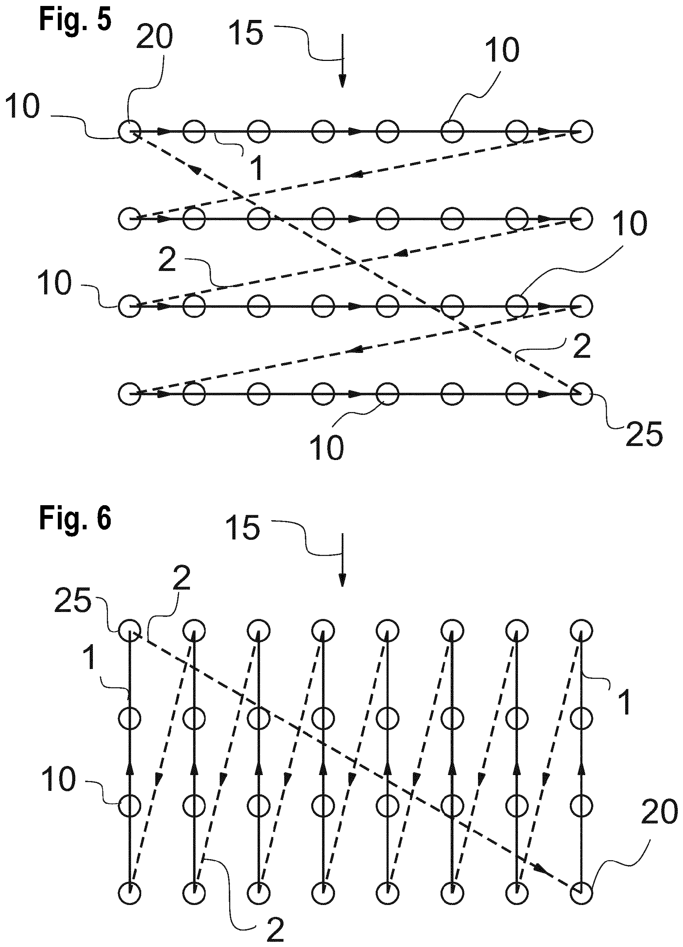

Referring now to Fig. 5, a set of areas according to an embodiment is shown. The set of areas may be the set of areas described in relation to Fig. 3 or 4. Only the differences to the embodiment described in relation to Fig. 3 or 4 shall be discussed. The sequence begins with the processing of area 20 in the top left corner of the set of areas. After the first line of areas has been processed, the laser beam is moved in a second laser beam movement direction to the leftmost area of the next line. The angle q2 is 250°, thus fulfilling condition 2.). Furthermore, the area is several areas distant from the prior area, thus fulfilling condition 3.). The return transition from area 25 to area 20 has a second laser beam movement direction with an angle q2 of 150°, thus fulfilling condition 1.).

Referring now to Fig. 6, a set of areas according to an embodiment is shown. The set of areas may be a set of areas as described in relation to Fig. 3 to 5, thus, only the differences in the positioning of the laser beam are described. The sequence can begin e.g. in the bottom right area 20. The following four areas are subsequently subjected to the laser beam along a line, i.e. the first laser beam movement direction, represented as a solid line, having an angle q1 of 180° relative to the fluid flow direction and thus fulfilling condition 1.).

When the top right area is reached, the laser beam is moved in a second laser beam movement direction to reach the bottommost area of the next line of areas. The second laser beam movement direction has an angle q2 of 345° relative to the fluid flow direction, thus, neither conditions 1.) or 2.) are fulfilled. However, the top right area 25 is several areas distant from the bottom right area 20, thus, condition 3.) is fulfilled. In practice, the distance is at least 10 areas, specifically more than 20 areas or even more than 30 areas.

The operations are repeated until the top left area 25 is reached, after which the second laser beam movement direction is adjusted to return the laser beam to the bottom right area 20. The angle for this movement q2 is 60°, thus fulfilling condition 2.). Furthermore, the area is several areas distant from the prior area, thus fulfilling condition 3.).

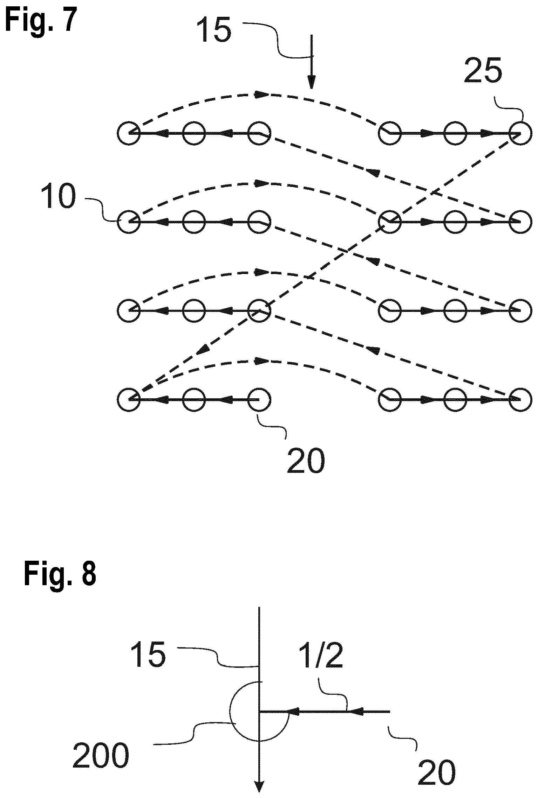

Referring now to Fig. 7, a set of areas according to an embodiment is shown. The set of areas is provided as a 4 by 6 array. The processing operation begins at area 20, which is provided at the bottom line of areas in the array, and moves outward along a first direction with an angle q1 of 270° until the outermost area is reached. The first direction of movement of the laser beam fulfills condition 1.). The laser beam is then moved in the laser beam movement direction q2 of 90° to reach an area in the line of areas in the array adjacent to starting area 20. It should be noted that the transition along the second direction is depicted in Fig. 7 as a curved line for reasons of intelligibility only, i.e. the transition may be performed according to a straight line. Thus, the second direction of movement of the laser beam fulfills condition 1.).

After the transition, the direction of the first laser beam movement direction q1 is adjusted to 90° and the areas of the line of areas in the array are processed until the outermost area is reached. Then, a transition into the next line of areas in the array of areas is performed with a second laser beam movement direction having an angle q2 of 110°, thus fulfilling condition 1.).

The operations are repeated until the top right area 25 is reached, after which the second laser beam movement direction is adjusted to return the laser beam to the bottom left area 20. The second laser beam movement direction for this movement in relation to the fluid flow direction q2 is 300°, thus, neither conditions 1.) or 2.) are fulfilled. However, the top right area is several areas distant from the bottom left area, thus, condition 3.) is fulfilled.

Directing the laser beam according to the described embodiments, particularly embodiments fulfilling either of the conditions 1.) to 3.) described above, a high-speed processing of the set of areas can be achieved, while simultaneously allowing each area of the set of areas to cool for at least 50 ms while the subsequent areas are processed according to the predefined sequence. Furthermore, the debris produced while performing the laser working is carried away by the fluid flow in a direction according to the fluid flow, while each laser shot is unaffected by the debris. Consequently, no unnecessary waiting times between laser shots need to be introduced, while maintaining a high processing quality otherwise not obtainable by known processes.

Fig. 8 aims to illustrate the angles q1 and q2. Where the arrow 15 stands for the fluid flow direction, the further arrow between the areas 20 may represent the first laser beam movement direction or the second laser beam movement direction. The angle between the first or second laser beam movement direction (denoted as "1/2" in Fig. 8) and the fluid flow direction is denoted with 200, and would be 270° in the present example of Fig. 8.

While the foregoing is directed to embodiments of the disclosure, other and further embodiments of the disclosure may be devised without departing from the basic scope thereof, and the scope thereof is determined by the claims that follow.

## Claims

1. An apparatus for hole drilling in a substrate (110), comprising:
a laser system (100) configured to apply a laser beam (120) onto the substrate for removing material from a set of areas (10, 20, 25) on the substrate by directing the laser beam onto predefined positions corresponding to the set of areas on the substrate in a sequence, the sequence defining the order in which the areas are subjected to the laser beam,
a ventilation system (125) configured to produce a fluid flow (15) along one or more sides of the substrate, the fluid flow being directed in a fluid flow direction;
a controller configured to control the laser beam such that the laser beam is sequentially positioned according to a first laser beam movement direction (1) and a second laser beam movement direction (2) with the laser beam being repeatedly directed onto each position corresponding to the set of areas at least three times, with at least half of the subjected areas being allowed to cool for at least 50 ms after each time an area from the set of areas is subjected to the laser beam, wherein the angle between the first laser beam movement direction and the fluid flow direction is defined as q1, the angle between the second laser beam movement direction and the fluid flow direction is defined as q2;
wherein either
both cos q1 and cos q2 are smaller than or equal to 0; or
each of q1 and q2 is larger than 20° and smaller than 340°; or
either q1 or q2 is smaller than 20°, or larger than 340°, and the laser beam movement is controlled such that the area which is subjected to the laser beam in the sequence is more than one area distant from the prior area subjected to the laser beam in the sequence.

2. The apparatus according to claim 1, wherein the second laser movement is such that the area which is subject to the laser beam in the sequence after the laser is moved by the second movement is more than five areas, particularly at least more than 10 areas distant from a prior area subjected to the laser beam in the sequence.

3. The apparatus according to claims 1 or 2, wherein the areas have a shape with a circumference, and wherein the laser beam is directed, under the control of the controller, onto predefined positions corresponding to the circumference of the areas.

4. The apparatus according to any of the preceding claims, wherein one of the first laser beam movement direction and the second laser beam movement direction is opposite to the fluid flow direction and/or wherein one of the first laser movement direction and the second laser movement direction is perpendicular to the fluid flow direction.

5. The apparatus according to any of the preceding claims, wherein the set of areas include at least 1,000 areas, particularly at least 10,000 areas, and more particularly at least 100,000 areas.

6. The apparatus according to any of the preceding claims, wherein the apparatus further comprising an enclosure, the enclosure including a gas inlet (130) and a gas outlet (135).

7. A method for drilling holes in a substrate (110), comprising:
applying a laser beam (120) onto the substrate by directing the laser beam onto predefined positions corresponding to a set of areas (10, 20, 25) on the substrate in a sequence, the sequence defining the order in which the areas are subjected to the laser beam, the laser beam removing material from the set of areas;
producing, while applying the laser beam onto the substrate, a fluid flow (15) along one or more sides of the substrate, the fluid flow being directed in a fluid flow direction;
applying the laser beam in a sequence including:
sequentially positioning the laser beam according to a first laser beam movement direction (1) and a second laser beam movement direction (2) with the laser beam being repeatedly directed onto each position corresponding to the set of areas at least five times, with at least half of the subjected areas being allowed to cool for at least 50 ms after each time an area from the set of areas is subjected to the laser beam, wherein the angle between the first laser beam movement direction and the fluid flow direction is defined as q1, the angle between the second laser beam movement direction and the fluid flow direction is defined as q2;
wherein either
both cos q1 and cos q2 are smaller than or equal to 0; or
each of q1 and q2 is larger than 20° and smaller than 340°; or
either q1 or q2 is smaller than 20°, or larger than 340°, and the laser beam movement is controlled such that the area which is subjected to the laser beam in the sequence is more than one area distant from the area subjected to the laser beam directly prior in the sequence.

8. The method according to claim 7, wherein the method includes carrying away, by the fluid flow, at least a portion of a debris produced when subjecting an area of the set of areas to the laser beam.

9. The method according to claims 7 or 8, wherein the method includes carrying away, by the fluid flow, at least a portion of one of the group of: an ionized gas, an aerosol, or an evaporated substrate material produced when subjecting an area of the set of areas to the laser beam.

10. The method according to any of claims 7 to 9, wherein the substrate includes one or more sets of areas.

11. The method according to any of claims 7 to 10, wherein the number of times the laser is directed onto the set of areas is a function of the substrate thickness depending on the substrate material, wherein the number of times is larger than a tenth of the substrate thickness in micrometers.

12. The method according to any of claims 7 to 11, wherein each of the subjected areas is allowed to cool for at least 50 ms, or wherein at least half of the subjected areas is allowed to cool for at least 50 to 100 ms, or for at least 100 ms, after each time an area from the set of areas is subjected to the laser beam.

13. The method according to any of claims 7 to 12, wherein the fluid flow includes one or more from the group consisting of an inert gas, in particular helium or argon, and nitrogen.

14. The method according to any of claims 7 to 13, wherein the fluid flow is a unidirectional laminar flow with a flow-rate of more than 1 m/s in the volume comprising the space of 1 mm to 2 mm above the one or more sides of the substrate.

15. The method according to any of claims 7 to 14, wherein the substrate is a silicon substrate or a substrate comprising a polymer film or a polymer composite film.

## Patentansprüche

1. Vorrichtung zum Bohren von Löchern in ein Substrat (110), umfassend:
ein Lasersystem (100), das so konfiguriert ist, dass es einen Laserstrahl (120) auf das Substrat anwendet, um Material aus einem Satz von Bereichen (10, 20, 25) auf dem Substrat zu entfernen, indem der Laserstrahl in einer Reihenfolge auf vordefinierte Positionen gerichtet wird, die mit dem Satz von Bereichen auf dem Substrat korrespondieren, wobei die Reihenfolge die Abfolge definiert, in der die Bereiche dem Laserstrahl ausgesetzt werden,
ein Belüftungssystem (125), das so konfiguriert ist, dass es einen Fluidstrom (15) entlang einer oder mehrerer Seiten des Substrats erzeugt, wobei der Fluidstrom in einer Fluidströmungsrichtung gerichtet ist;
eine Steuereinheit, die so konfiguriert ist, dass sie den Laserstrahl so steuert, dass der Laserstrahl sequenziell gemäß einer ersten Laserstrahlbewegungsrichtung (1) und einer zweiten Laserstrahlbewegungsrichtung (2) positioniert wird, wobei der Laserstrahl wiederholt auf jede Position gerichtet wird, die mit dem Satz von Bereichen korrespondiert, und zwar mindestens dreimal, wobei mindestens die Hälfte der ausgesetzten Bereiche nach jedem Aussetzen eines Bereichs aus dem Satz von Bereichen mit dem Laserstrahl mindestens 50 ms lang abkühlen kann, wobei der Winkel zwischen der ersten Laserstrahlbewegungsrichtung und der Fluidströmungsrichtung als q1 definiert ist, der Winkel zwischen der zweiten Laserstrahlbewegungsrichtung und der Fluidströmungsrichtung als q2 definiert ist;
wobei entweder
sowohl cos q1 als auch cos q2 kleiner oder gleich 0 sind; oder
jeder der Winkel q1 und q2 größer als 20° und kleiner als 340° ist; oder
entweder q1 oder q2 kleiner als 20° oder größer als 340° ist, und die Laserstrahlbewegung so gesteuert wird, dass der Bereich, der in der Reihenfolge dem Laserstrahl ausgesetzt ist, mehr als einen Bereich von dem zuvor in der Reihenfolge dem Laserstrahl ausgesetzten Bereich entfernt ist.

2. Vorrichtung nach Anspruch 1, wobei die zweite Laserbewegung so ist, dass der Bereich, der in der Reihenfolge nach der zweiten Bewegung des Lasers dem Laserstrahl ausgesetzt ist, mehr als fünf Bereiche, insbesondere mindestens mehr als 10 Bereiche, von einem vorherigen Bereich entfernt ist, der in der Reihenfolge dem Laserstrahl ausgesetzt war.

3. Vorrichtung nach Anspruch 1 oder 2, wobei die Bereiche eine Form mit einem Umfang aufweisen, und wobei der Laserstrahl unter der Steuerung der Steuereinheit auf vordefinierte Positionen gerichtet wird, die mit dem Umfang der Bereiche korrespondieren.

4. Vorrichtung nach einem der vorstehenden Ansprüche, wobei eine der ersten Laserstrahlbewegungsrichtungen und die zweite Laserstrahlbewegungsrichtung entgegengesetzt zur Fluidströmungsrichtung ist und/oder wobei eine der ersten Laserbewegungsrichtungen und die zweite Laserbewegungsrichtung senkrecht zur Fluidströmungsrichtung ist.

5. Vorrichtung nach einem der vorstehenden Ansprüche, wobei die Menge von Bereichen mindestens 1.000 Bereiche, insbesondere mindestens 10.000 Bereiche und insbesondere mindestens 100.000 Bereiche umfasst.

6. Vorrichtung nach einem der vorstehenden Ansprüche, wobei die Vorrichtung ferner ein Gehäuse umfasst, wobei das Gehäuse einen Gaseinlass (130) und einen Gasauslass (135) umfasst.

7. Verfahren zum Bohren von Löchern in ein Substrat (110), umfassend:
Anwenden eines Laserstrahls (120) auf das Substrat, indem der Laserstrahl auf vordefinierte Positionen gerichtet wird, die mit einem Satz von Bereichen (10, 20, 25) auf dem Substrat in einer Reihenfolge korrespondieren, wobei die Reihenfolge die Abfolge definiert, in der die Bereiche dem Laserstrahl ausgesetzt werden, wobei der Laserstrahl Material aus dem Satz von Bereichen entfernt;
Erzeugen einer Fluidströmung (15) entlang einer oder mehrerer Seiten des Substrats, während der Laserstrahl auf das Substrat angewendet wird, wobei die Fluidströmung in einer Fluidströmungsrichtung gerichtet ist;
Anwenden des Laserstrahls in einer Sequenz, die umfasst:
sequentielles Positionieren des Laserstrahls gemäß einer ersten Laserstrahlbewegungsrichtung (1) und einer zweiten Laserstrahlbewegungsrichtung (2), wobei der Laserstrahl wiederholt auf jede Position, die mit dem Satz von Bereichen korrespondiert, mindestens fünfmal gerichtet wird, wobei mindestens die Hälfte der ausgesetzten Bereiche nach jedem Aussetzen eines Bereichs aus dem Satz von Bereichen mit dem Laserstrahl mindestens 50 ms lang abkühlen kann, wobei der Winkel zwischen der ersten Laserstrahlbewegungsrichtung und der Fluidströmungsrichtung als q1 definiert ist, der Winkel zwischen der zweiten Laserstrahlbewegungsrichtung und der Fluidströmungsrichtung als q2 definiert ist;
wobei entweder
sowohl cos q1 als auch cos q2 kleiner oder gleich 0 sind; oder
jeder der Winkel q1 und q2 größer als 20° und kleiner als 340° ist; oder
entweder q1 oder q2 kleiner als 20° oder größer als 340° ist, und die Laserstrahlbewegung so gesteuert wird, dass der Bereich, der in der Reihenfolge dem Laserstrahl ausgesetzt ist, mehr als einen Bereich von dem Bereich entfernt ist, der unmittelbar zuvor in der Reihenfolge dem Laserstrahl ausgesetzt war.

8. Verfahren nach Anspruch 7, wobei das Verfahren das Abtransportieren mindestens eines Teils der Rückstände, die entstehen, wenn ein Bereich vom dem Satzes von Bereichen dem Laserstrahl ausgesetzt wird, durch die Fluidströmung umfasst.

9. Verfahren nach Anspruch 7 oder 8, wobei das Verfahren das Abtransportieren mindestens eines Teils einer der folgenden Gruppen durch den Fluidstrom umfasst: ein ionisiertes Gas, ein Aerosol oder ein verdampftes Substratmaterial, das erzeugt wird, wenn ein Bereich des Satzes von Bereichen dem Laserstrahl ausgesetzt wird.

10. Verfahren nach einem der Ansprüche 7 bis 9, wobei das Substrat eine oder mehrere Sätze von Bereichen umfasst.

11. Verfahren nach einem der Ansprüche 7 bis 10, wobei die Anzahl der Male, die der Laser auf die Sätze von Bereichen gerichtet wird, eine Funktion der Substratdicke in Abhängigkeit vom Substratmaterial ist, wobei die Anzahl größer ist als ein Zehntel der Substratdicke in Mikrometern.

12. Verfahren nach einem der Ansprüche 7 bis 11, wobei jeder der ausgesetzten Bereiche mindestens 50 ms lang abkühlen kann, oder wobei mindestens die Hälfte der ausgesetzten Bereiche mindestens 50 bis 100 ms lang oder mindestens 100 ms lang abkühlen kann, nachdem jeweils ein Bereich aus dem Satz von Bereichen dem Laserstrahl ausgesetzt wurde.

13. Verfahren nach einem der Ansprüche 7 bis 12, wobei der Fluidstrom ein oder mehrere aus der Gruppe bestehend aus einem Inertgas, insbesondere Helium oder Argon, und Stickstoff umfasst.

14. Verfahren nach einem der Ansprüche 7 bis 13, wobei der Fluidstrom ein unidirektionaler laminarer Strom mit einer Strömungsgeschwindigkeit von mehr als 1 m/s in dem Volumen ist, das den Raum von 1 mm bis 2 mm über der einen oder den mehreren Seiten des Substrats umfasst.

15. Verfahren nach einem der Ansprüche 7 bis 14, wobei das Substrat ein Siliziumsubstrat oder ein Substrat ist, das eine Polymerfolie oder eine Polymerverbundfolie umfasst.

## Revendications

1. Appareil de perçage de trous dans un substrat (110), comprenant :
un système laser (100) configuré pour appliquer un faisceau laser (120) sur le substrat à des fins de retrait de matériau d'un ensemble de zones (10, 20, 25) sur le substrat en dirigeant le faisceau laser sur des positions prédéfinies correspondant à l'ensemble de zones sur le substrat selon une séquence, la séquence définissant l'ordre dans lequel les zones sont soumises au faisceau laser,
un système de ventilation (125) configuré pour produire un écoulement de fluide (15) le long d'un ou de plusieurs côtés du substrat, l'écoulement de fluide étant dirigé dans un sens d'écoulement de fluide ;
un organe de commande configuré pour commander le faisceau laser de sorte que le faisceau laser soit positionné successivement conformément à un premier sens de déplacement de faisceau laser (1) et à un second sens de déplacement de faisceau laser (2), le faisceau laser étant dirigé de manière répétée au moins trois fois sur chaque position correspondant à l'ensemble de zones, au moins la moitié des zones soumises étant laissée refroidir pendant au moins 50 ms après chaque soumission au faisceau laser d'une zone de l'ensemble de zones, dans lequel l'angle entre le premier sens de déplacement de faisceau laser et le sens d'écoulement de fluide est défini en tant que q1, l'angle entre le second sens de déplacement de faisceau laser et le sens d'écoulement de fluide est défini en tant que q2 ;
dans lequel soit
cos q1 et cos q2 sont tous les deux inférieurs ou égaux à 0 ; soit
q1 et q2 sont individuellement supérieurs à 20° et inférieurs à 340° ; soit
l'un ou l'autre de q1 ou de q2 est inférieur à 20°, ou supérieur à 340°, et le déplacement de faisceau laser est commandé de sorte que la zone qui est soumise au faisceau laser selon la séquence corresponde à plus d'une zone distante de la zone précédente soumise au faisceau laser selon la séquence.

2. Appareil selon la revendication 1, dans lequel le second déplacement de laser est tel que la zone qui est soumise au faisceau laser selon la séquence après le déplacement du laser correspondant au second déplacement soit supérieure à cinq zones, particulièrement à plus de 10 zones au minimum distantes d'une zone précédente soumise au faisceau laser selon la séquence.

3. Appareil selon les revendications 1 ou 2, dans lequel les zones ont une forme ayant une circonférence, et dans lequel le faisceau laser est dirigé, sous la commande de l'organe de commande, sur des positions prédéfinies correspondant à la circonférence des zones.

4. Appareil selon l'une quelconque des revendications précédentes, dans lequel l'un du premier sens de déplacement de faisceau laser et du second sens de déplacement de faisceau laser est contraire au sens d'écoulement de fluide et/ou dans lequel l'un du premier sens de déplacement de faisceau laser et du second sens de déplacement de faisceau laser est perpendiculaire au sens d'écoulement de fluide.

5. Appareil selon l'une quelconque des revendications précédentes, dans lequel l'ensemble de zones comprend au moins 1 000 zones, particulièrement au moins 10 000 zones, et plus particulièrement au moins 100 000 zones.

6. Appareil selon l'une quelconque des revendications précédentes, dans lequel l'appareil comprend en outre un boîtier, le boîtier comprenant un orifice d'entrée de gaz (130) et un orifice de sortie de gaz (135).

7. Procédé de perçage de trous dans un substrat (110), comprenant les étapes consistant à :
appliquer un faisceau laser (120) sur le substrat en dirigeant le faisceau laser sur des positions prédéfinies correspondant à un ensemble de zones (10, 20, 25) sur le substrat selon une séquence, la séquence définissant un ordre dans lequel les zones sont soumises au faisceau laser, le faisceau laser retirant du matériau de l'ensemble de zones ;
produire, tout en appliquant le faisceau laser sur le substrat, un écoulement de fluide (15) le long d'un ou de plusieurs côtés du substrat, l'écoulement de fluide étant dirigé dans un sens d'écoulement de fluide ;
appliquer le faisceau laser selon une séquence comprenant :
un positionnement successif du faisceau laser conformément à un premier sens de déplacement de faisceau laser (1) et à un second sens de déplacement de faisceau laser (2), le faisceau laser étant dirigé de manière répétée au moins cinq fois sur chaque position correspondant à l'ensemble de zones, au moins la moitié des zones soumises étant laissée refroidir pendant au moins 50 ms après chaque soumission au faisceau laser d'une zone de l'ensemble de zones, dans lequel l'angle entre le premier sens de déplacement de faisceau laser et le sens d'écoulement de fluide est défini en tant que q1, l'angle entre le second sens de déplacement de faisceau laser et le sens d'écoulement de fluide est défini en tant que q2 ;
dans lequel soit
cos q1 et cos q2 sont tous les deux inférieurs ou égaux à 0 ; soit
q1 et q2 sont individuellement supérieurs à 20° et inférieurs à 340° ; soit
l'un ou l'autre de q1 ou de q2 est inférieur à 20°, ou supérieur à 340°, et le déplacement de faisceau laser est commandé de sorte que la zone qui est soumise au faisceau laser selon la séquence corresponde à plus d'une zone distante de la zone directement précédente soumise au faisceau laser selon la séquence.

8. Procédé selon la revendication 7, dans lequel le procédé comprend l'étape consistant à évacuer, par l'écoulement de fluide, au moins une partie de débris produits lors de la soumission au faisceau laser d'une zone de l'ensemble de zones.

9. Procédé selon les revendications 7 ou 8, dans lequel le procédé comprend l'étape consistant à évacuer, par l'écoulement de fluide, au moins une partie d'un élément du groupe comprenant : un gaz ionisé, un aérosol, ou un matériau de substrat évaporé produit lors de la soumission au faisceau laser d'une zone de l'ensemble de zones.

10. Procédé selon l'une quelconque des revendications 7 à 9, dans lequel le substrat comprend un ou plusieurs ensembles de zones.

11. Procédé selon l'une quelconque des revendications 7 à 10, dans lequel le nombre de fois selon lequel le faisceau laser est dirigé sur l'ensemble de zones est une fonction de l'épaisseur du substrat dépendant du matériau de substrat, dans lequel le nombre de fois est supérieur à un dixième de l'épaisseur de substrat en micromètres.

12. Procédé selon l'une quelconque des revendications 7 à 11, dans lequel chacune des zones soumises est laissée refroidir pendant au moins 50 ms, ou dans lequel au moins la moitié des zones soumises est laissée refroidir pendant au moins 50 à 100 ms, ou pendant au moins 100 ms après chaque soumission au faisceau laser d'une zone de l'ensemble de zones.

13. Procédé selon l'une quelconque des revendications 7 à 12, dans lequel l'écoulement de fluide comprend un ou plusieurs gaz du groupe constitué d'un gaz inerte, en particulier d'hélium ou d'argon, et d'azote.

14. Procédé selon l'une quelconque des revendications 7 à 13, dans lequel l'écoulement de fluide est un écoulement laminaire unidirectionnel ayant un débit supérieur à 1 m/s dans le volume comprenant l'espace de 1 mm à 2 mm au-dessus du ou des côtés du substrat.

15. Procédé selon l'une quelconque des revendications 7 à 14, dans lequel le substrat est un substrat en silicium ou un substrat comprenant un film polymère ou un film composite à base de polymères.
